# EUROPÄISCHE PATENTSCHRIFT

(11) **EP 0 351 756 B1**
(45) Veröffentlichungstag und Bekanntmachung des Hinweises auf die Patenterteilung: **26.05.1993**
(21) Anmeldenummer: 89113076.7
(22) Anmeldetag: 17.07.1989
(51) Int. Cl.: H02H 7/20, H01L 27/02

(54) **Schaltungsanordnung zum Schutze einer integrierten Schaltung vor einem an einer Eingangsstufe anliegenden unzulässigen Eingangspotential**
Circuit arrangement for protecting an integrated circuit against a non-allowed input voltage imposed on an input stage
Circuit de protection d'un circuit intégré contre une tension d'entrée inadmissible imposée à un étage d'entrée

(30) Priorität: 20.07.1988 DE 3824678
(43) Veröffentlichungstag der Anmeldung: 24.01.1990
(73) Patentinhaber: SIEMENS AKTIENGESELLSCHAFT, 80333 München (DE)
(72) Erfinder: Horchler, Wolfgang, Dipl.-Ing., D-8013 Haar (DE); Lenz, Michael, Ing. grad., D-8011 Zorneding (DE)

(56) Entgegenhaltungen:
- FR-A- 2 590 726
- US-A- 4 496 849

## Beschreibung

Bei integrierten Schaltungen, vor allem bei unipolar betriebenen, führen unzulässige Eingangspotentiale, wie sie etwa durch Verpolung oder induktive Kopplung am Eingang entstehen können, zu Fehlfunktionen bis hin zu der Zerstörung der integrierten Schaltung. Um dem entgegenzuwirken, werden gefährdete Eingänge beispielsweise mit Dioden beschaltet. Insbesondere bei integrierten Schaltungen mit hohem Eingangswiderstand ist diese Vorgehensweise jedoch kritisch, da die Dioden zum einen eine relativ hohe Durchlaßspannung und zum anderen einen nicht zu vernachlässigenden Durchgangswiderstand aufweisen. Dabei zeigen integrierte Schaltungen, die einen PNP-Transistor in der Eingangsstufe zur Erzielung eines hohen Eingangswiderstandes besitzen, eine erhöhte Empfindlichkeit gegenüber unzulässigen Eingangspotentialen. Dies ist durch die Tatsache begründet, daß die Basis eines PNP-Transitors in einer integrierten Schaltung aus einer n-dotierten Wanne in einem p-dotierten Substrat besteht. Mit weiteren in der integrierten Schaltung vorhandenen n-dotierten Wannen entstehen dadurch parasitäre, als NPN-Transistoren wirkende Strukturen, welche beim Auftreten eines gegenüber dem Nullpotential negativen unzulässigen Potential an der Basis des PNP-Transistors aktiviert werden und mit weiteren Schaltungsteilen in Wechselwirkung geraten.

Um dem entgegenzuwirken, wird üblicherweise ein an ein positives Potential angeschlossener n-dotierter Schutzring um den betreffenden PNP-Transistor gelegt und/oder der den PNP-Transistor umgebende Isolationsrahmen vergrößert. Durch beide Maßnahmen wird jedoch der Einfluß des parasitären lateralen NPN-Transistors auf die integrierte Schaltung über die Verringerung seines Basisstromes durch Abschirmung bzw. über das Herabsetzen seiner Stromverstärkung lediglich abgeschwächt, jedoch nicht aufgehoben. Zudem können diese strukturellen Eingriffe zu unerwünschten Veränderungen bei den elektrischen Eigenschaften der integrierten Schaltung führen.

Aufgabe der Erfindung ist es, die Wirkungen eines an einer Eingangsstufe einer integrierten Schaltung anliegenden unzulässigen Eingangspotentials auf die Funktionsfähigkeit der integrierten Schaltung gering zu halten.

Die Aufgabe wird beim einer gattungsgemäßen Schaltungsanordnung durch die kennzeichnenden Merkmale des Patentanspruchs 1 gelöst.

Weiterbildungen der Erfindung sind Gegenstand von Unteransprüchen.

Vorteil der Erfindung ist es, mit geringem schaltungstechnischen Aufwand die Funktionsfähigkeit einer integrierten Schaltung beim Auftreten eines unzulässigen Eingangspotentials über einen weiten Bereich hin zu erhalten. Darüber hinaus eignet sich die erfindungsgemäße Schaltungsanordnung aufgrund des hohen Durchgangswiderstandes im regulären Betriebsfall besonders für integrierte Schaltungen mit hohem Eingangswiderstand.

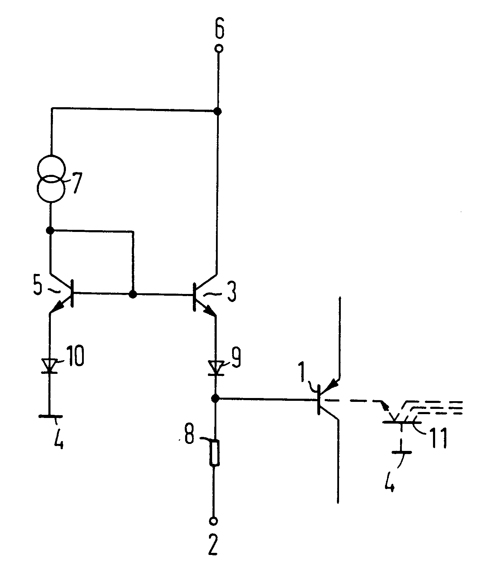

Ein Ausführungsbeispiel der Erfindung ist in der einzigen Figur der Zeichnung dargestellt und wird im folgenden näher beschrieben.

Bei dem gezeigten Ausführungsbeispiel ist die Eingangsstufe durch einen PNP-Eingangstransistor 1 gegeben, der emitter- und kollektorseitig mit nicht näher bezeichneten Teilen einer unipolar betriebenen integrierten Schaltung verschaltet ist und dessen Basis als Eingang der integrierten Schaltung vorgesehen ist. In Verbindung mit dem p-dotierten Substrat als Basis und weiteren n-dotierten Wannen als Kollektoren bildet die Basis des PNP-Eingangstransistors 1 den Emitter einer parasitären, als NPN-Mehrfach-Kollektortransistor wirkenden und im folgenden als parasitärer NPN-Transistor 11 bezeichneten Schaltungsstruktur. Der parasitäre NPN-Transistor 11 ist dabei über die Basis mit Masse als Nullpotential 4 und über die Kollektoren mit weiteren Schaltungsteilen der integrierten Schaltung verbunden.

Die erfindungsgemäße Schaltungsanordnung besteht aus einem ersten NPN-Transistor 3, dessen Kollektor an einem gegenüber dem Nullpotential 4 positiven Versorgungspotential 6 liegt und dessen Basis an der Basis und dem Kollektor eines zweiten NPN-Transistors 5 sowie an einer von dem Versorgungspotential 6 ausgehenden Stromquelle 7 angeschlossen ist. In Weiterbildung der Erfindung ist der Emitter des zweiten NPN-Transitors 5 über eine in Durchlaßrichtung geschaltete Diode 10 an das Nullpotential 4 gelegt und der Emitter des ersten NPN-Transistors 3 über eine weitere in Durchlaßrichtung geschaltete Diode 9 mit der Basis des PNP-Eingangstransistors 1 verbunden. Darüber hinaus ist die Basis des PNP-Eingangstransistors 1 die Erfindung weiterbildend über einen ohmschen Widerstand 8 mit dem Eingangspotential 2 beaufschlagt.

Nachdem zuvor der prinzipielle Aufbau der in der Figur der Zeichnung dargestellten Schaltungsanordnung erläutert worden ist, sei nunmehr auf deren Arbeitsweise näher eingegangen.

In Verbindung mit der Stromquelle 7 erzeugen der zu einer Diode verschaltete zweite NPN-Transistor 5 und die in Reihe dazu geschaltete Diode 10 zwischen dem an der Basis des ersten NPN-Transistors 3 anliegenden Potential und dem Nullpotential 4 eine Potentialdifferenz, welche der Summe der beiden Diodendurchlaßspannungen entspricht. Für den Fall, daß das Eingangspotential 2 gleich dem Nullpotential 4 ist, oder positiver, ist der erste NPN-Transistor 3 gesperrt, da die an ihm anliegende Basis-Emitter-Spannung zum Durchsteuern nicht ausreicht. Wird dagegen das Eingangspotential 2 negativ gegenüber dem Nullpotential 4, so wird auch die Basis-Emitter-Spannung des ersten NPN-Transistors 3 groß genug, um diesen in den leitenden Zustand zu bringen. Damit fließt ein Strom von dem positiven Versorgungspotential 6 in den Basiskreis des PNP-Eingangstransistors 1, wo sich, durch das Regelverhalten der Schaltungsanordnung bedingt, in etwa das Nullpotential 4 einstellt. Der über den ohmschen Widerstand 8 aus dem Basiskreis des PNP-Eingangstransistors 1 zum Eingangspotential 2 fließende Strom wird durch den Emitter-Kollektor-Strom des ersten NPN-Transistors 3 wieder aufgehoben.

Der ohmsche Widerstand 8 dient vorteilhafterweise zur Begrenzung des Eingangsstromes und wird zweckmäßigerweise bei Eingangsspannungsquellen mit geringem Innenwiderstand eingesetzt. Die beiden in die Emitterkreise der beiden NPN-Transistoren 3, 5 eingebrachten Dioden 9, 10 bringen den Vorteil mit sich, daß ein hohes positives Eingangspotential aufgrund des Sperrens der Diode 9 nicht zu einem Durchbruch der Basis-Emitter-Strecke des ersten NPN-Transistors 3 führt. Die Diode 10 dient dazu, den an der Diode 9 austretenden Spannungsabfall zu kompensieren. Die beiden Dioden 9, 10 werden bevorzugt in einer hochsperrenden Ausführung verwendet.

Abschließend sei bemerkt, daß sich aufgrund des geringen schaltungstechnischen Aufwandes eine Mitintegration, insbesondere bei integrierten Schaltungen mit mehreren zu schützenden Eingängen anbietet.

## Patentansprüche

1. Schaltungsanordnung zum Schutze einer integrierten Schaltung vor einem an einer Eingangsstufe (1) anliegenden unzulässigen Eingangspotential (2), **dadurch gekennzeichnet**, daß die Eingangsstufe (1) mit dem Emitter eines ersten Transistors (3) verbunden ist, daß der Kollektor des ersten Transistors (3) an einem Versorgungspotential (6) angeschlossen ist, daß die Basis des ersten Transistors (3) mit einer auf das Versorgungspotential (6) bezogenen Stromquelle (7) und mit der Basis und dem Kollektor eines emitterseitig auf einem Nullpotential (4) liegenden zweiten Transistor (5) verschaltet ist und daß das Versorgungspotential (6) und das unzulässige Eingangspotential (2) bezogen auf das Nullpotential (4) eine einander entgegengesetzte Polarität aufweisen.

2. Schaltungsanordnung nach Anspruch 1, **dadurch gekennzeichnet**, daß das unzulässige Eingangspotential (2) an einem Anschluß eines ohmschen Widerstandes (8), dessen zweiter Anschluß mit dem Emitter des ersten Transistors (3) und mit der Eingangsstufe (1) verbunden ist, anliegt.

3. Schaltungsanordnung nach Anspruch 1 oder 2, **dadurch gekennzeichnet**, daß die Emitter der beiden Transistoren mit zusätzlichen, in Durchlaßrichtung geschalteten Dioden beaufschlagt sind.

## Claims

1. Circuit arrangement for protecting an integrated circuit against an impermissible input potential (2) applied to an input stage (1), characterised in that the input stage (1) is connected to the emitter of a first transistor (3), in that the collector of the first transistor (3) is connected to a supply potential (6), in that the base of the first transistor (3) is connected to a current source (7), referred to the supply potential (6), and to the base and the collector of a second transistor (5) whose emitter is at a zero potential (4), and in that the supply potential (6) and the impermissible input potential (2), referred to the zero potential (4), have a mutually opposite polarity.

2. Circuit arrangement according to Claim 1, characterised in that the impermissible input potential (2) is applied to a terminal of an ohmic resistor (8), whose second terminal is connected to the emitter of the first transistor (3) and to the input stage (1).

3. Circuit arrangement according to Claim 1 or 2, characterised in that the emitters of the two transistors are coupled to additional diodes which are connected in the forward direction.

## Revendications

1. Circuit de protection d'un circuit intégré contre un potentiel d'entrée (2) inadmissible et appliqué à un étage d'entrée (1), caractérisé en ce que l'étage d'entrée (1) est relié à l'émetteur d'un premier transistor (3), en ce que le collecteur du premier transistor (3) est porté à un potentiel d'alimentation (6), en ce que la base du premier transistor (3) est reliée à une source de courant (7) rapportée au potentiel d'alimentation (6) et à la base et au collecteur d'un deuxième transistor (5) placé, côté émetteur, à un potentiel nul (4), et en ce que le potentiel d'alimentation (6) et le potentiel d'entrée (2) inadmissible rapportés au potentiel nul (4), présentent une polarité réciproquement inverse.

2. Circuit selon la revendication 1, caractérisé en ce que le potentiel d'entrée (2) inadmissible est appliqué à une borne d'une résistance ohmique (8) dont la deuxième borne est reliée à l'émetteur du premier transistor (3) et à l'étage d'entrée (1).

3. Circuit selon la revendication 1 ou 2, caractérisé en ce que les émetteurs des deux transistors sont reliés à des diodes supplémentaires montées en direct.
